# EUROPEAN PATENT APPLICATION

(11) **EP 2 472 273 A2**
(43) Date of publication of application: **04.07.2012**
(21) Application number: 11460065.3
(22) Date of filing: 27.12.2011
(51) Int. Cl.: G01R 19/00

(54) **Battery current measuring**

(30) Priority: 28.12.2010 PL 39345210
(71) Applicant: Instytut Lacznosci Panstwowy Instytut Badawczy, 04-894 Warszawa (PL)
(72) Inventor: Niechoda Kazimierz, 04-331 Warszawa (PL); Olechowski Krzysztof, 03-909 Warszawa (PL); Godlewski, Pawel, 04-955 Warszawa (PL); Kobus, Rsyzard, 01-926 Warszawa (PL); Chojnacki, Bogdan, 01-355 Warszawa (PL)

(57) **Abstract**

Method and system for measuring current, especially the battery charge and discharge current is applied in telecommunications and is used for contactless current measurement in the power systems of the telecommunications devices. The storage batteries of high or medium capacity are joined in parallel to the first battery clamp (BAT1), the second battery clamp (BAT2) and the third battery clamp (BAT3). After connecting of the battery, the capacitor of the reversible converter (PR) is charged through the thermistor (PTC) with a voltage of the battery, then a cycle of control charging/discharging of the battery begins by switching-on the reversible converter (PR) and switching the contacts of the excess current circuit-breaker (W), and the current value is measured using the first transducer (LM) and the second transducer (LD). In the system for measuring the charging/discharging current of the battery, the first battery clamp (BAT1) is connected to the second input (LM2) of the first transducer (LM), while the first input (LM1) of the first transducer (LM) is connected to the second contact (2) of the excess current circuit-breaker (W) and the second terminal (PTC2) of the thermistor (PTC), and the second clamp (BAT2) is connected to the fourth contact (4) of the excess current circuit-breaker (W), while the third clamp (BAT3) is connected to the sixth contact (6) of the excess current circuit-breaker (W).

## Description

The present invention relates to a method and a system for measuring current, especially the current of battery charge and discharge applicable in the field of telecommunications for contactless current measurement in the power systems of the telecommunications devices.

In the power systems of the telecommunications devices one needs sometimes to control charging and discharging of the storage batteries. If one makes it with use of the portable devices they shall be adjusted to co-operation with different batteries in a wide range of their capacity. Since the recommended charge and discharge current of the battery depends on its capacity, such portable devices should measure the value of a current in a wide range, e.g. from 2 A to 160 A with high accuracy.

In a method of measuring the output current of the converter by measuring the current of the keyer, known from the Polish patent application PL382094, the current of the keyer is measured, then it is converted to voltage and subsequently averaged through the switching time of the keyer, and finally the voltage correlated with the converter output current is obtained.

Circuits for the contactless measuring of a current are commonly known and applied. In the systems based on a Hall transducer, known from the American patent documents US2006/0284611A1 and US4823075, the current value is converted to the voltage value, which in turn can be measured by means of an analog-to-digital converter.

According to the Polish patent application PL383277 a system providing complex service of the lead-acid accumulator batteries, especially VRLA, in a buffer mode the DC/DC converter is connected to the measuring module, low-pass filter, and a microprocessor control system, which is connected to a number of cells of the battery.

Known transducers for measuring the current value are designed for specified ranges of measured currents (6A, 10A, 16A, 25A, 50A, 100A), and their accuracy ranges from 0.5% to 1%. Obtaining of high accuracy over a wide range of the current values is not possible. For a wide range of values of measured currents a solution based on the measuring range switch is not advantageous, because it generates a large energy loss.

A method of measuring a current, especially the battery charge and discharge current according to the invention is characterized in that the storage batteries with high or medium capacity are attached optionally to: the first battery clamp, the second battery clamp and the third battery clamp, or a storage battery with low capacity is attached to the first battery clamp, and after connecting of the batteries the capacitor of the reversible converter is charged through the thermistor positron with a voltage of the battery, then a cycle of control charging/discharging of the battery begins by switching-on the reversible converter and switching the contacts of the excess current circuit-breaker, and the current value is measured with use of the first transducer and the second transducer, and through the first transducer and the second transducer the current value is converted to the measuring voltage, which is fed from the outputs of both transducers to the first input and the second input of the multichannel converter, connected to the control unit, and then using the control unit an evaluation of the current measurement results is made based on comparing of the results from the second transducer and from the first transducer, and based on the results obtained from the control unit it is decided which one of these results will be included in further calculations, and after finishing of the battery testing, using the control unit the undercurrent release is triggered and the contacts of the excess current circuit-breaker are disconnected.

A system for measuring current, especially the battery charge and discharge current, according to the invention is characterized in that between the battery with high or medium power coupled in parallel with the first battery clamp, the second battery clamp, the third battery clamp, the positive clamp, and a reversible converter, the battery charge/discharge current measuring system is connected, in which the first battery clamp is connected to the second input of the first transducer, while the first input of the first transducer is connected to the second contact of the excess current circuit-breaker and the second terminal of the thermistor positron, and the second clamp is connected to the fourth contact of the excess current circuit-breaker, while the third clamp is connected to the sixth contact of the excess current circuit-breaker, while the first contact, the third contact, and the fifth contact of the excess current circuit-breaker are connected to the first terminal of the positron and the second input of the second transducer, and the first input of the second transducer is connected to the output of the reversible converter, while the output of the second transducer is connected to the first input of the multichannel converter, and the output of the first transducer is connected to the second input of the multichannel converter, and the output of the multichannel converter is connected to the input of the control unit, which is connected to the undervoltage release, and preferably a storage battery with low power is attached only to the first battery clamp.

The advantage of the method and system for measuring current, especially the battery charge and discharge current according to the invention is the ability to measure current, with high accuracy, in wide range of values. Significant increase in accuracy is achieved, of about four times in measurement of small currents, and besides, protection of the transducers from damage resulting from the current flow with a value exceeding the measurement range is another advantage of the method. Advantageously, no additional elements such as the range switches, which may affect the reliability of the system, are needed in the invented system.

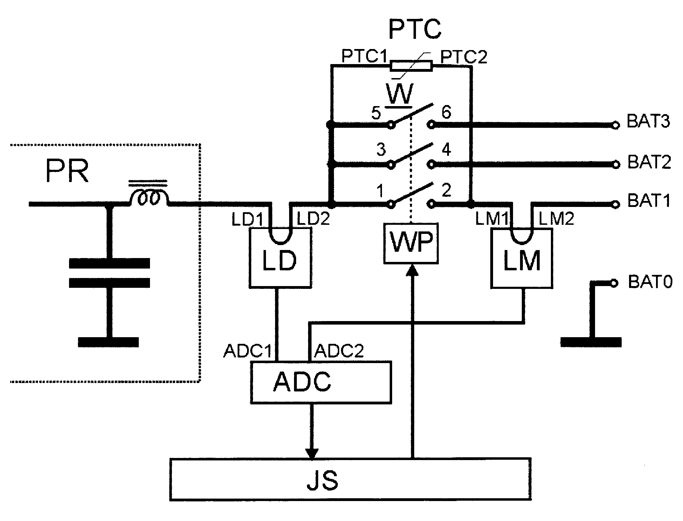

Preferable embodiment of the system according to the invention for measuring current, especially the battery charge and discharge current, is illustrated on the figure showing a block diagram of the system.

In the system for measuring current, especially the battery charge and discharge current, according to the invention between the battery coupled in parallel with the first battery clamp BAT1, the second battery clamp BAT2, the third battery clamp BAT3, the positive clamp BAT0, and a reversible converter PR, the battery charge/discharge current measuring system is connected, in which the first battery clamp BAT1 is connected to the second input LM2 of the first transducer LM, while the first input LM1 of the first transducer LM is connected to the second contact 2 of the excess current circuit-breaker W and the second terminal PTC2 of the thermistor PTC, and the second clamp BAT2 is connected to the fourth contact 4 of the excess current circuit-breaker W, while the third clamp BAT3 is connected to the sixth contact 6 of the excess current circuit-breaker W, while the first contact 1, the third contact 3, and the fifth contact 5 of the excess current circuit-breaker W are connected to the first terminal PTC1 of the thermistor PTC and the second input LD2 of the second transducer LD, and the first input LD1 of the second transducer LD is connected to the output of the reversible converter PR, while the output of the second transducer LD is connected to the first input ADC1 of the multichannel converter ADC, and the output of the first transducer LM is connected to the second input ADC2 of the multichannel converter ADC, and the output of the multichannel converter ADC is connected to the input of the control unit JS, which is connected to the undervoltage release WP.

The storage battery is connected for control charge and discharge to the first battery clamp BAT1, the second battery clamp BAT2, and the third battery clamp BAT3. Due to the electric resistance of the terminals the battery with high or medium capacity is attached to all three terminals. If the test is subjected to the storage battery with low capacity and the charge/discharge current does not exceed 63 A, it is attached only to the first battery clamp BAT1.

In the solution invented for contactless measurement of current in the power systems of telecommunications devices, two Hall transmitters for two significantly different current values are applied. This allows for a significant increase in accuracy in measuring small currents. The method of connecting of the first transmitter LM and the second transmitter LD fully protects the transducers against damage resulting from the current flow with a value exceeding the measuring range. In this solution there are no additional elements such as the range switches, which may affect the reliability of the system.

After the battery is attached, the capacitor of the reversible converter PR (not covered by the application) is charged through thermistor PTC with the battery voltage, to avoid sudden flow of current during the system switching. Then a cycle of control charging/discharging of the battery begins by switching-on the reversible converter PR and switching the contacts of the excess current circuit-breaker W, which protects all three circuits and after exceeding of the current value in one of the circuits it is disconnected. The current value is measured with use of two transducers for contactless measurement of currents: the first transducer LM, connected into the circuit of -BAT1, and the second transducer LD which is used to measure the sum of currents of the three circuits. The other side of the first transducer LM is connected to the output of the reversible converter PR. Through the first transducer LM and the second transducer LD the current value is converted to the measuring voltage, which is fed from the outputs of both transducers to the first input ADC1 and the second input ADC2 of the multichannel converter ADC, connected to the control unit JS. Using the control unit JS, which is not provided with the data on how the tested battery is connected, an evaluation of the current measurement results is made based solely on comparing of the results from the second transducer LD and from the first transducer LM, and it is decided which one of these results will be included in further calculations.

If the current value measured by the second transmitter LD is much higher (about 3 times) than the current value measured by the first transducer LM, then the current value measured by the second transmitter LD is to be assumed in further calculations. If the current values measured by the second transducer LD and the first transducer LM are equal or close to each-other, the current value obtained from the first transducer LM is to be accepted. The first transducer LM has smaller measurement range and thus it provides the measurement absolute accuracy several times higher. The first transducer LM is protected against exceeding the measuring range and possible damage with the excess current circuit-breaker W. After finishing the battery test cycle, using the control unit JS the undervoltage release WP is triggered and the contacts of the excess current circuit-breaker (W) are disconnected.

## Claims

1. A method of measuring current, especially the battery charge and discharge current, in which the current is measured and then converted to voltage, **characterized in that** the batteries with high or medium capacity are joined in parallel to the first battery clamp (BAT1), the second battery clamp (BAT2) and the third battery clamp (BAT3), and after connecting of the batteries, the capacitor of the reversible converter (PR) is charged through the thermistor (PTC) with a voltage of the battery, then a cycle of control charging/discharging of the battery begins by switching-on the reversible converter (PR) and switching the contacts of the excess current circuit-breaker (W), and the current value is measured with use of the first transducer (LM) and the second transducer (LD), and through the first transducer (LM) and the second transducer (LD) the current value is converted to the measuring voltage, which is fed from the outputs of both transducers to the first input (ADC1) and the second input (ADC2) of the multichannel converter (ADC), connected to the control unit (JS), and then using the control unit (JS) an evaluation of the current measurement results is made based on comparing of the results from the second transducer (LD) and from the first transducer (LM), and based on the results obtained from the control unit (JS) it is decided which one of these results will be included in further calculations, and after finishing of the battery testing, using the control unit (JS) the undervoltage release (WP) is triggered and the contacts of the excess current circuit-breaker (W) are disconnected.

2. The method according to claim 1, **characterized in that** the storage battery with low capacity is attached to the first clamp (BAT1) of the battery.

3. A system for measuring current, especially the battery charge and discharge current, containing a converter, an analog-digital converter, the Hall transducers and a control device, **characterized in that** between the battery with high or medium power coupled in parallel with the first battery clamp (BAT1), the second battery clamp (BAT2), the third battery clamp (BAT3), the positive clamp (BAT0), and a reversible converter (PR), the battery charge/discharge current measuring system is connected, in which the first battery clamp (BAT1) is connected to the second input (LM2) of the first transducer (LM), while the first input (LM1) of the first transducer (LM) is connected to the second contact (2) of the excess current circuit-breaker (W) and the second terminal (PTC2) of the thermistor (PTC), and the second clamp (BAT2) is connected to the fourth contact (4) of the excess current circuit-breaker (W), while the third clamp (BAT3) is connected to the sixth contact (6) of the excess current circuit-breaker (W), while the first contact (1), the third contact (3), and the fifth contact (5) of the excess current circuit-breaker (W) are connected to the first terminal (PTC1) of the thermistor (PTC) and the second input (LD2) of the second transducer (LD), and the first input (LD1) of the second transducer (LD) is connected to the output of the reversible converter (PR), while the output of the second transducer (LD) is connected to the first input (ADC1) of the multichannel converter (ADC), and the output of the first transducer (LM) is connected to the second input (ADC2) of the multichannel converter (ADC), and the output of the multichannel converter (ADC) is connected to the input of the control unit (JS), which is connected to the undervoltage release (WP).

4. The system according to claim 3, **characterized in that** the measuring system of charging/discharging of the battery is connected between a low-power battery joined to the first clamp (BAT1) of the battery, and the reversible converter (PR).
